(19) Europäisches Patentamt / European Patent Office / Office européen des brevets

(11) **EP 2 629 089 B1**

(12) **EUROPÄISCHE PATENTSCHRIFT**

(45) Veröffentlichungstag und Bekanntmachung des Hinweises auf die Patenterteilung:
**03.04.2019 Patentblatt 2019/14**

(51) Int Cl.:
***G01N 29/07*** *(2006.01)*     ***G01N 29/46*** *(2006.01)*
***G01N 29/44*** *(2006.01)*

(21) Anmeldenummer: **12194790.7**

(22) Anmeldetag: **29.11.2012**

(54) **Verfahren und Vorrichtung zur Wavelet-basierten Laufzeitmessung von Ultraschallimpulsen**

Method and apparatus for wavelet-based propagation time measurement of ultrasonic pulses

Procédé et dispositif de mesure de temps de propagation d'impulsions ultrasonores basée sur des ondelettes

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.02.2012 DE 102012202189**

(43) Veröffentlichungstag der Anmeldung:
**21.08.2013 Patentblatt 2013/34**

(73) Patentinhaber: **Sonotec Ultraschallsensorik Halle GmbH**
**06112 Halle / Saale (DE)**

(72) Erfinder:
- **Münch, Hans-Joachim**
 **06130 Halle (DE)**
- **zur Horst-Meyer, Santer**
 **06120 Halle (DE)**
- **Bodi, Andreas**
 **06295 Lutherstadt Eisleben**
 **Ortsteil Wolferode (DE)**
- **Holstein, Peter**
 **04425 Leipzig (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
**EP-A1- 2 369 334    DE-A1-102005 015 456**

- **GUETBI C ET AL: "Flow velocity estimation using ultrasound signals and wavelet transformation", INDUSTRIAL ELECTRONICS SOCIETY, 1998. IECON '98. PROCEEDINGS OF THE 24 TH ANNUAL CONFERENCE OF THE IEEE AACHEN, GERMANY 31 AUG.-4 SEPT. 1998, NEW YORK, NY, USA,IEEE, US, Bd. 3, 31. August 1998 (1998-08-31), Seiten 1366-1369, XP010308304, DOI: 10.1109/IECON.1998.722850 ISBN: 978-0-7803-4503-4**
- **GRIMALDI D ED - YATSKIV N: "Time-of-flight measurement in ultrasound transducer by means of wavelet networks", INTELLIGENT DATA ACQUISITION AND ADVANCED COMPUTING SYSTEMS: TECHNOLOG Y AND APPLICATIONS, 2003. PROCEEDINGS OF THE SECOND IEEE INTERNATIONAL WORKSHOP ON SEPT. 8-10, 2003, PISCATAWAY, NJ, USA,IEEE, PISCATAWAY, NJ, USA, 8. September 2003 (2003-09-08), Seiten 365-370, XP010671828, DOI: 10.1109/IDAACS.2003.1249588 ISBN: 978-0-7803-8138-4**

**Beschreibung**

Die vorliegende Erfindung betrifft ein Verfahren und eine Vorrichtung zur Messung von Laufzeiten von Ultraschallsignalen sowie eine entsprechende Vorrichtung.

Stand der Technik

Vor allem im Bereich der zerstörungsfreien Materialprüfung haben sich ultraschallbasierte Verfahren etabliert. Eine Vielzahl von Anwendungen basiert dabei auf der Laufzeitmessung von Ultraschallimpulsen. Bei diesen Verfahren wird ein elektrischer Impuls von einem Ultraschallsensor in einen Ultraschallimpuls, im Folgenden als Sendeimpuls bezeichnet, umgewandelt. Durch die Ankopplung des Sensors an ein Messobjekt wird der Sendeimpuls in das Messobjekt eingekoppelt. An der Grenzfläche zu einem anderen Medium wird ein Teil des Sendeimpulses reflektiert, im Folgenden als Echo bezeichnet. Diese Reflektion kann innerhalb eines Mediums mehrfach erfolgen. Dadurch werden diese Mehrfachreflektionen als Mehrfachechos bezeichnet. Bei Ultraschall basierten Messverfahren werden diese Echos von einem Ultraschallsensor erfasst und wieder in ein elektrisches Signal umgewandelt. Dient dieser Ultraschallsensor gleichzeitig als Sensor, der den Sendeimpuls generiert hat, so spricht man vom Impuls-Echo-Verfahren, andernfalls vom Sender-/Empfänger-Verfahren. Durch die Bestimmung der Laufzeit der Echos, oder der Mehrfachechos kann die Lage der Reflektionsstelle im Messobjekt bestimmt werden.

Dem Stand der Technik nach sind verschiedene Möglichkeiten zur Laufzeitmessung von Signalen, insbesondere von Ultraschallsignalen bekannt. Die charakteristischen Punkte zur Zeitmessung im Signal sind dabei das Herauswachsen des Signals aus dem Rauschen, das Verschwinden des Signals im Rauschen, Maxima der positiven oder negativen Schwingungszüge und das absolute Maxima des Signals.

Beim sogenannten Triggerverfahren wird mit einer möglichst hohen Verstärkung, z.B. im Bereich 40-60dB, der Anfang des Echos im Messsignal gesucht. Dies ist der Punkt des Herauswachsens des Echos aus dem Rauschen. Nachteilig im Triggerverfahren ist, dass durch die endliche Verstärkung die Zeitmessung nur mit einer gewissen Ungenauigkeit ermittelt werden kann. Außerdem macht die hohe Verstärkung das Gerät empfindlich in Hinsicht auf elektromagnetische Verträglichkeit. Da bei diesem Verfahren nur nach dem Beginn des Signals gesucht wird ist zudem keine Unterscheidung zwischen eventuell vorhandenen Störsignalen und den eigentlichen Nutzsignalen möglich.

Die Digitalisierung eines analogen Signals ermöglicht dabei im Vergleich zur rein analogen Signalverarbeitung eine genaure Bestimmung der Signaleigenschaften wie zum Beispiel die Laufzeit eines Signals. Die Genauigkeit für die Bestimmung der zeitlichen Lage eines Punktes im Signal ist dabei abhängig von der Abtastrate des Systems bzw. der zeitlichen Auflösung des Signals. Daraus folgt, dass mit der Steigerung der Anforderungen an die Genauigkeit auch die Kosten und die Stromaufnahme steigen. Schnelle Analog-Digital-Wandler sind verfügbar aber teuer. Ferner steigt durch die höhere Abtastrate ebenfalls das erforderliche Speichervolumen.

Zu den genannten Verfahren gibt es verschiedene Alternativen, wie z.B. die Durchführung der Messung in mehreren Schritten. Dabei kann zunächst die Abtastrate zum Suchen von Bereichen in denen ein Echo vorhanden ist klein gewählt werden. Es können Bereiche vordefiniert werden, in denen mit einer höheren Abtastrate gemessen werden soll. Es kann zunächst mit niedriger Abtastrate ein Echo gesucht werden und dann gegebenenfalls erneut mit höherer Abtastung gemessen werden. Die Durchführung der Messung in mehreren Schritten ist jedoch fehleranfällig, da Signale leicht übersehen werden können. Zudem sind Messungen in mehreren Schritten schwer reproduzierbar. Hohe Abtastraten wären aber auch hier erforderlich, es würde lediglich der Speicherbedarf reduziert werden.

In einer weiteren Variante kann die Abtastrate durch zeitversetztes Messen erhöht werden. Dies erfordert eine exakte zeitliche Steuerung im Nanosekundenbereich. Dabei ist Vorraussetzung, dass sich das Signal innerhalb der Messzyklen nicht verändert, was allerdings nicht vorhersehbar ist. Ferner erfordert diese Variante einen zusätzlichen Rechenaufwand zum Zusammensetzen des Messsignals. Es wird zwar eine Reduktion der Anforderungen an den Analog-Digital-Wandler erreicht, allerdings ist dafür eine hohe Speicherkapazität erforderlich.

Zur Analyse stationärer Signale ist die Fouriertransformation geeignet. Ferner sind zur Analyse insbesondere von sich zeitlich verändernden Funktionen oder Signalen beispielsweise die Korrelationsanalyse, die Kurzzeitfouriertransformation sowie die Wavelet-Transformation bekannt.

In der Physik nimmt die Fouriertransformation eine wichtige Rolle ein, denn sie stellt die Verknüpfung zwischen Zeitraum und Frequenzraum her und ermöglicht damit die direkte Erfassung spektraler Eigenschaften aus dem Zeitsignal. Die Fourier-Transformation (FT) ist dabei eine Integraltransformation, die einer gegebenen Funktion eine andere Funktion, nämlich ihre Fourier-Transformierte, zuordnet.

Die Short-Time-Fourier-Transformation (STFT) ist eine Modifikation der Fourier-Transformation zur Berechnung des Zeit-Frequenz-Spektrums eines Signals. Die STFT umgeht ein Problem der Fouriertransformation, die keine Aussage über das zeitliche Auftreten einzelner Frequenzen oder Frequenzbereiche macht. Bei der STFT wird nur ein zeitlich begrenzter Abschnitt des Signals betrachtet. Dazu multipliziert man das Signal mit einer Fensterfunktion und berechnet für das ausgeschnittene Signal die Fourier-Koeffizienten. Für jeden Punkt der STFT wird das Fenster an den zu betrachtenden Zeitpunkt und an die zu betrachtende Frequenz (Modulation im Zeitbereich) verschoben. Die Basisfunktionen bei der FT und der STFT sind trigonometrische Funktionen.

Die Wavelet-Transformation kann als Modifikation der STFT angesehen werden. Der Begriff "Wavelet" bezieht sich dabei auf die für die Transformation benutzte Basisfunktionen, mit der das zu analysierende Signal "verglichen" wird.

Ein "Wavelet" ist dabei eine zeitlich begrenzte Funktion und dadurch gekennzeichnet, dass man im Gegensatz zur Fourier-Transformation zeitlich lokalisierte Funktionen mit bestimmten Eigenschaften als Basis benutzt, wodurch eine adaptive Zeit- und Frequenzauflösung möglich wird. Wie bei der STFT wird das zu untersuchende Signal mit einer Fensterfunktion verglichen. Anstatt allerdings das Fenster wie bei der STFT zu verschieben und zu modulieren, wird das Fenster verschoben und skaliert. Die kontinuierliche Wavelet-Transformation der Funktion x(t) ist gegeben durch:

$$W_\Psi(a,b) = \frac{1}{a} \int_{-\infty}^{\infty} \overline{\Psi\left(\frac{t-b}{a}\right)} x(t)dt \qquad \{a \in \mathbb{R}: a \neq 0; b \in \mathbb{N}\} \qquad (1)$$

mit dem Dilatationsparameter "a" und dem Translationsparameter "b". Die Funktion $\Psi$ wird Basiswavelet oder Motherwavelet genannt.

Durch die Analog-Digital-Wandlung wird aus dem analogen zeitkontinuierlichen Signal ein digitales zeitdiskretes Signal. Es erfolgt deshalb der Übergang von der kontinuierlichen Wavelet-Transformation zur diskreten Wavelet-Transformation.

$$W_{diskr}(a,b) = \frac{1}{a} \sum_n \Psi\left(\frac{n-b}{a}\right) x[n] \qquad \{a \in \mathbb{R}: a \neq 0; b \in \mathbb{N}\} \qquad (2)$$

Bei der Kreuzkorrelation wird das gemessene Signal mit einem Referenzsignal verglichen. Das Ergebnis der Kreuzkorrelation ist zum einen ein Maß für die Ähnlichkeit beider Signale und zum anderen ein Wert der zeitlichen Verschiebung zwischen beiden Signalen. Der Korrelationskoeffizient

$$K(\tau) = \int y(t)x(t+\tau)dt \qquad (3)$$

ergibt sich aus einem Referenzsignal y(t), mit dem das Messsignal x(t) verglichen wird. Die zeitliche Verschiebung spiegelt der Parameter $\tau$ wieder.

Aus der DE 10 2005 015 456 A1 ist ein Verfahren zur Bestimmung der zeitlichen Lage eines Wellenpaketes in einem Durchflussmessgerät bekannt. Das Verfahren umfasst das Abtasten des Wellenpakets zu einer Vielzahl von Zeitpunkten. Die zeitliche Lage des Wellenpakets wird schließlich mittels einer Kreuzkorrelation bestimmt. Der eigentliche Auflösungsgewinn wird durch iteratives Berechnen des Kreuzkorrelationsfaktors zwischen dem Messsignal und einem Sinus bzw. Kosinusbasierten Motherwavelet erreicht. Mit Hilfe dieses Korrelationsverfahrens wird versucht die Phasenlage des Signals so genau wie möglich zu bestimmen.. Eine hohe Abtastrate bedingt eine hohe Auflösung, eine niedrige Abtastrate eine niedrige Auflösung. Eine Laufzeit wird hierbei nicht direkt bestimmt. EP 2 369 334 A1 beschreibt eine Zeit-Frequenz-Transformation zur Extraktion von einzelnen Wellenmoden. Die Bestimmung der Laufzeit erfolgt direkt aus den digitalisierten Daten, wobei eine hohe Abtastrate eine hohe Auflösung und eine niedrige Abtastrate eine niedrige Auflösung bedingt. Weitere Dokumente des Standes der Technik zur Wavelet Transformation und deren Anwendung sind GUETBI C ET AL: "Flow velocity estimation using ultrasound signals and wavelet transformation", INDUSTRIAL ELECTRONICS SOCIETY, 1998. IECON '98. PROCEEDINGS OF THE 24TH ANNUAL CONFERENCE OF THE IEEE AACHEN, GERMANY 31 AUG.-4 SEPT. 1998, NEW YORK, NY, USA,IEEE, US, Bd. 3, 31. August 1998 (1998-08-31), Seiten 1366-1369, XP010308304, DOI: 10.1109/IECON.1998.722850, ISBN: 978-0-7803-4503-4 und GRIMALDI D ED-YATSKIV N: "Time-of-flight measurement in ultrasound transducer by means of wavelet networks", INTELLIGENT DATA ACQUISITION AND ADVANCED COMPUTING SYSTEMS: TECHNOLOG Y AND APPLICATIONS, 2003. PROCEEDINGS OF THE SECOND IEEE INTERNATIONAL WORKSHOP ON SEPT. 8-10, 2003, PISCATAWAY, NJ, USA,IEEE, PISCATAWAY, NJ, USA, 8. September 2003 (2003-09-08), Seiten 365-370, XP010671828, DOI: 10.1109/IDAACS.2003.1249588, ISBN: 978-0-7803-8138-4. In beiden Dokumenten wird eine Wavelet-Transformation mit dem abgetasteten Signal durchgeführt.

Aufgabe der Erfindung ist es daher ein kompaktes, kostengünstiges und präzises Verfahren sowie eine entsprechende Vorrichtung zur Bestimmung der Laufzeit anzugeben.

Offenbarung der Erfindung

Das erfindungsgemäße Verfahren zur Bestimmung der Laufzeiten eines Ultraschallimpulses umfasst folgende Schritte:

Verfahren zur Bestimmung der Laufzeiten eines Ultraschallimpulses umfassend die Schritte der Auswahl eines Basiswavelets, des Sendens eines Ultraschallmessimpulses, des Durchlaufens einer Messstrecke, des Empfangens und Abtastens des ausgesendeten Ultraschallmessimpulses als Empfangssignal, des Skalierens des Empfangssignals auf eine vordefinierte Genauigkeit $\Delta t$ für die zu bestimmende Signallaufzeit, der Wavelet-Transformation auf Basis des ausgewählten Basiswavelets und des skalierten Empfangssignals, und der Bestimmung der Laufzeit des Ultraschallmessimpulses aus dem Ergebnis der Wavelet-Transformation. Der Schritt des Skalierens des Ultraschallmessimpulses umfasst dabei das Einfügen von mindestens einer Null zwischen je zwei Abtastpunkten des Ultraschallmessimpulses derart, dass das Einfügen von *k* Nullen

$$(k \in \mathbb{N})$$

zu einer zeitlichen Auflösung von

$$\Delta t = \frac{\frac{1}{f_s}}{k+1},\tag{4}$$

führt.

Durch die Verwendung der Wavelettransformation auf Basis des skalierten Empfangssignals und des hochaufgelösten Basiswavelets kann die Laufzeit mit einer gegenüber der eigentlichen Abtastrate $f_S$ verbesserten zeitlichen Auflösung bestimmt werden.

In einem Ausführungsbeispiel wird die Laufzeitbestimmung zur Wandstärkenmessung verwendet. Das Ultraschallmesssignal wird dabei von einer Grenzfläche reflektiert und dann erst empfangen. Bevorzugt wird die Laufzeit dabei zwischen zwei benachbarten Echos des Ultraschallmessimpulses bestimmt. Die Anzahl der Echos kann aber auch größer gewählt werden. Dann kann z. B. eine statistische Mittelung der einzeln bestimmten Laufzeiten vorgenommen werden.

Das Ergebnis der Wavelettransformation ist dabei eine Funktion W(a, b), bei der der erste Parameter "a" der Wavelet-Transformation eine reelle Zahl ungleich Null ist, und der zweite Parameter "b" eine natürliche Zahl ist. Der erste Parameter wird üblicherweise als Dilatationsparameter eingeführt und skaliert das Wavelet. Der zweite Parameter wird üblicherweise als Translationsparameter bezeichnet. Der Schritt der Bestimmung der Laufzeit umfasst bevorzugt das Bestimmen des optimalen Werts des ersten Parameters $a_{opt}$ des Wavelets und das Auswählen der Wavelet-Transformation mit dem optimalen Wert des ersten Parameters W($a_{opt}$, b). Der Schritt der Bestimmung des optimalen Wertes des ersten Parameters $a_{opt}$ umfasst die Schritte des Bestimmens des Maximums $W_{max}(a)$ aus W(a,b) separat zu jedem Wert des ersten Parameters a und für beliebige Werte des zweiten Parameters b, und das Bestimmen des optimalen Wertes des ersten Parameters $a_{opt}$ aus der Position des Maximums von $W_{max}(a)$. Darauf folgt die Bestimmung des zweiten Parameters b an dessen Stelle der zum Ultraschallmessimpuls gehörige Impuls im Empfangssignal liegt und die Bestimmung der Laufzeit des Ultraschallmessimpulses aus dem Produkt des bestimmten zweiten Parameters b und der zeitlichen Genauigkeit $\Delta t$.

Im Schritt des Auswählens eines Basiswavelets kann das Basiswavelet aus einer Gruppe von bekannten Basiswavelets ausgewählt werden, insbesondere Haar-, Daubechies-, biorthogonale Basiswavelets. Es kann aber auch ein Basiswavelet erzeugt werden. Die Abweichung des ausgewählten oder erzeugten Basiswavelets von dem empfangenen Ultraschallmesssignal ist dabei minimal bzw. liegt unter einem vordefinierten Schwellwert für die Abweichung.

Der optimale Wert des ersten Parameters $a_{opt}$ entspricht bevorzugt der Position des Maximums von $W_{max}(a)$. Alternativ ist auch die Bestimmung des Energieinhaltes zu jeder Skalierung möglich.

Für die Bestimmung der Position des zum Ultraschallmessimpuls gehörigen Impulses im Empfangssignal werden gängige und etablierte Verfahren der Auswertung von Ultraschall-A-Bildern genutzt. Damit wird der Wert des Parameters b bestimmt, an dessen Stelle der zum Ultraschallmessimpuls gehörige Impuls im Empfangssignal liegt. Die dazugehörige Signallaufzeit t ergibt sich nach:

$$t = b * \Delta t.\tag{5}$$

Beim Bestimmen der Laufzeit zwischen zwei Echos eines ausgesendeten Ultraschallimpulses wird die gleiche Prozedur auf das nächste Echo angewandt. An der Stelle des zweiten Echos des Ultraschallmessimpulses wird der Wert des Parameters $b_{Echo2}$ und die Laufzeit $t_{Echo2}$ bestimmt. Aus diesen Werten von t kann dann die Laufzeit zwischen beiden Echos nach

$$t = t_{Echo2} - t_{Echo1} \hspace{4cm} (6)$$

bestimmt werden.

Für eine Erhöhung der Genauigkeit können weitere Echos in die Berechnung der Laufzeitdifferenzen einbezogen werden.

Die Ultraschallsignale werden bevorzugt durch breitbandige Signale im Bereich zwischen 500 kHz und 200 MHz erzeugt.

In einem Ausführungsbeispiel werden zu Beginn des Verfahrens die Abtastrate des Ultraschallmessimpulses und die gewünschte zeitliche Auflösung der zu bestimmenden Laufzeit festgelegt. Ferner wird ein Schwellwert zur Unterscheidung eines Signals vom Untergrundrauschen in der Wavelet-Transformierten W(a, b) festgelegt.

Die zeitliche Auflösung des skalierten Empfangssignals ist dabei ein Vielfaches der zeitlichen Auflösung des Empfangssignals selbst.

Ferner ist eine Vorrichtung zur Bestimmung der Laufzeit eines Ultraschallimpulses vorgesehen, bestehend aus einem Sender, einer Messsonde, einem Empfänger, einer mit dem Sender und dem Empfänger verbundenen Recheneinheit und einem Speicher, wobei die Recheneinheit dazu ausgelegt ist, das erfindungsgemäße Verfahren auszuführen.

Entsprechend wird eine Vorrichtung zur Bestimmung der Laufzeit von Ultraschallsignalen bestehend aus einem Sender, einer Sonde, einem Empfänger, einer mit dem Sender und dem Empfänger verbundenen Recheneinheit und einem Speicher vorgeschlagen, wobei die Recheneinheit dazu ausgelegt ist, das erfindungsgemäße Verfahren auszuführen.

In einem bevorzugten Ausführungsbeispiel ist die Vorrichtung ein Wanddickenmessgerät. Alternativ kann sie ein Durchflussmessgerät, ein Füllstands- oder ein Entfernungsmessgerät sein. Die Vorrichtung kann nach dem Impuls-Echo-, dem Sender-Empfänger- oder dem Durchschallungsverfahren arbeiten.

Vorteilhafte Weiterbildungen der Erfindung sind in den Unteransprüchen angegeben und in der Beschreibung beschrieben.

Die Verwendung der Wavelet-Transformation, also eines Verfahrens, welches zur Lokalisierung von Signalen mit Hilfe charakteristischer Signalformen, sogenannter Wavelets verwendet wird, ermöglicht es, die Abtastrate des Analog-Digital-Wandlers des eigentlichen Messsystems soweit zu reduzieren, dass das Nyquist-Theorem noch erfüllt ist. Beispielsweise müssten bei einem 2.5 MHz Prüfkopf (100% Bandbreite) die Abtastrate bei >7.5 MHz liegen. Mit der Verwendung eines 10 MS/s Analog-Digital-Wandlers würde man ein sehr schlecht abgetastetes Signal erhalten. Die Genauigkeit der Zeitmessung würde demnach max. 100ns (0.6 mm Stahl) betragen. Mit Hilfe der Wavelet-Transformation ist es möglich, die Laufzeit zwischen zwei oder mehr Echos eines Sendesignals zu bestimmen. Die Genauigkeit der Messung hängt dann von der Auflösung des Wavelets ab und nicht mehr von der Abtastrate des Messsystems. Es wäre also vorteilhafterweise möglich, eine Genauigkeit von 1ns mit einer Abtastung von 10 MHz zu erreichen. Dies spart Kosten, da die Anforderungen an den AD-Wandler und den Speicher nicht so hoch sind. Weiterhin ist eine erhebliche Senkung des Stromverbrauchs damit verbunden. Zudem sind schnelle Mikrocontroller mit DSP Funktionalität zu moderaten Preisen erhältlich.

Zeichnungen

Ausführungsbeispiele der Erfindung werden anhand der Zeichnungen und der nachfolgenden Beschreibung näher erläutert. Es zeigen:

Figur 1 eine Vorrichtung zur Laufzeitmessung,

Figur 2 ein abgetastetes Ultraschallmesssignal,

Figur 3 ein auf die gewünschte zeitliche Auflösung skaliertes Empfangssignal,

Figur 4 das Ergebnis W(a, b) der Wavelettransformation mit einem ausgewählten Basiswavelet und einem skalierten Empfangssignal in einem ersten Ausführungsbeispiel,

Figur 5 das Ergebnis der Wavelettransformation W(a, b) mit abgeschnittenem Ausschwingbereich,

Figur 6 das zu jeder Skalierung a zugehörige Maximum der Wavelet-Transformation W(a, b),

Figur 7 das ausgewählte Ergebnis W($a_{opt}$, b) der Wavelet-Transformation aus Figur 6.

Ausführungsformen der Erfindung

Die Ausführungsformen der Erfindung werden im Folgenden anhand der Bestimmung der Laufzeit eines Ultraschallsignals aufgezeigt. Die Ausführung bezieht sich auf breitbandige Ultraschallsignale im Frequenzbereich zwischen 500 kHz und 200 MHz.

Die Erfindung wird anhand der Anwendung der Laufzeitmessung nach dem Impuls-Echo-Verfahren beschrieben, ist darauf aber nicht beschränkt. Sie kann ebenfalls für die Laufzeitmessung nach dem Sender/Empfänger Verfahren verwendet werden.

Das Grundprinzip der im Folgenden rein beispielhaft vorgestellten Laufzeitbestimmung basiert bei der Wanddickenmessung auf der Detektion von einem Echo und mindestens einem Mehrfachecho.

Der Zeitunterschied zwischen der Erfassung eines Echos und des darauf folgenden Mehrfachechos ergibt die zu bestimmende Laufzeit durch das zu untersuchende Material.

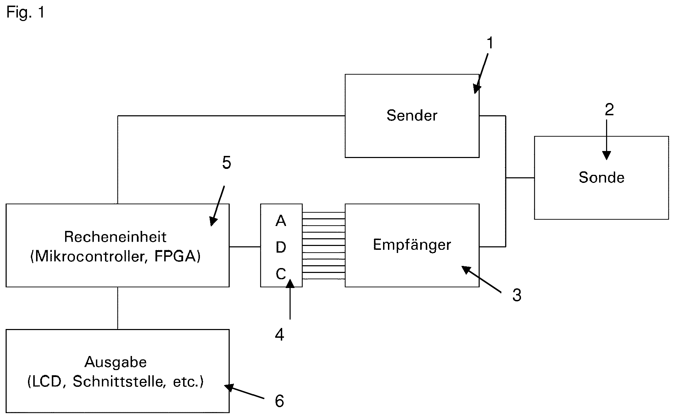

Figur 1 zeigt eine entsprechende Vorrichtung zur Bestimmung der Laufzeit. Ein Sender 1 generiert einen elektrischen Impuls, welcher von der Sonde 2 in einen Ultraschallimpuls umgewandelt wird. Durch die Ankopplung der Sonde wird der Ultraschallimpuls in ein Messobjekt eingekoppelt. Das daraus resultierende Echo, sowie die darauffolgenden Mehrfachechos werden über eine Sonde 2 empfangen und in ein elektrisches Signal umgewandelt. Dieses elektrische Signal wird von einem Empfänger 3 aufgenommen und an einen Analog-Digital-Wandler 4 weitergereicht. Der Analog-Digital-Wandler 4 ist wiederum mit einer Recheneinheit 5 wie zum Beispiel einem Mikrocontroller verbunden. Die Recheinheit 5 ist mit dem Sender 1, dem Empfänger 3 über den AD-Wandler 4 sowie eine Ausgabeeinheit 6 verbunden. Ferner weist die Vorrichtung einen Speicher (nicht gezeigt) auf, in dem Messdaten und Parameter der Messung gespeichert werden können.

Die Laufzeit wird im Folgenden nicht beschränkend und rein beispielhaft zwischen zwei aufeinanderfolgenden Echos eines Sendeimpulses bestimmt.

Jedoch kann auch lediglich ein Echo zu Laufzeitbestimmung verwendet werden. Dabei wird der Sendezeitpunkt eines Messimpulses registriert und die Zeit zwischen Aussenden des Messimpulses und Empfangen eines einzigen Echos bestimmt. So kann der Empfänger 3 über einen Trigger (nicht gezeigt) oder die Recheneinheit 5 bei Beginn des Sendens des Messimpulses gestartet werden.

Vor der eigentlichen Laufzeitmessung werden zunächst einmal die Messparameter definiert. So wird die Abtastrate $f_s$ der gemessenen Empfangssignale unter Berücksichtigung des Nyquist-Theorems festgelegt. Auch werden die gewünschten Auswerteparameter festgelegt. Es wird zudem die gewünschte Genauigkeit $\Delta t$ für die Bestimmung der Laufzeit des Messimpulses festgelegt.

Bei der eigentlichen Messung wird zunächst vom Sender 1 ein elektrischer Impuls erzeugt, welcher von der Sonde 2 in einen Ultraschallimpuls umgewandelt wird. Dieser Ultraschallimpuls wird in ein Messobjekt eingekoppelt. Der sich im Messobjekt ausbreitende Sendeimpuls wird an der Grenzfläche des Messobjektes zu einem anderen Medium reflektiert. Das dadurch entstehende Echo wird an der nächsten Grenzfläche zwischen dem Messobjekt und einem anderen Medium wieder reflektiert und erzeugt ein erstes Mehrfachecho dieses Mehrfachecho erzeugt wiederum ein Mehrfachecho usw. Die somit entstehende Echofolge wird von der Sonde 2 in ein elektrisches Signal umgewandelt und vom Empfänger 3 dem Analog-Digital-Wandler 4 zugeführt. Das vom Analog-Digital-Wandler 4 mit der Abtastrate $f_S$ abgetastete Signal wird im internen Speicher der Vorrichtung abgelegt. Dies geschieht über einen bestimmten, vordefinierten Zeitraum in dem das bzw. die Echos zu erwarten sind.

Für die Auswertung wird zudem ein Basiswavelet definiert. Die Wahl des Basiswavelets hängt dabei vom jeweiligen Anwendungsfall ab. Die Form des Basiswavelets entspricht dabei möglichst genau der Form eines Echos. Es wird also zunächst einmal ein Sendeimpuls in ein Messobjekt eingekoppelt, ein Echo empfangen und ein Basiswavelet derart ausgewählt, dass es eine minimale Abweichung zur Form des Echos aufweist. Um dies zu erreichen, kann eines der aus der Literatur bekannten Basiswavelets, wie z. B. ein Haar-, Daubechies- oder ein biorthogonales Basiswavelet verwendet werden oder es wird ein neues Wavelet über geeignete Software unter der Bedingung der minimalen Abweichung von der Form des Echos generiert.

Zudem wird ein Schwellwert für die Bewertung des extrahierten Ergebnisvektors aus der Wavelet-Transformation festgelegt. Dieser gibt einen Schwellwert für die Unterscheidung von "Signal" zu "kein Signal" an. Der Schwellwert ist eine vordefinierte Zahl, im einfachsten Fall ein einzustellender Parameter. Alle Werte, die in der Wavelet-Transformierten unterhalb dieses Schwellwertes liegen werden für die Auswertung ignoriert. Es werden nur Werte oberhalb des Schwellwertes betrachtet.

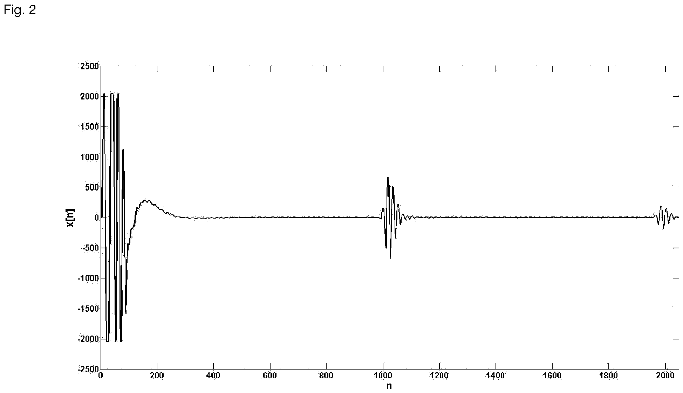

In Figur 2 ist ein empfangenes, abgetastetes Ultraschallmesssignal mit dem Sendeimpuls, dem ersten Echo und dem darauffolgenden Mehrfachecho dargestellt. Auf der x-Achse sind die n-Abtastwerte angegeben, auf der y-Achse der entsprechende abgetastete Empfangssignalwert x[n] in beliebigen Einheiten. Die ersten knapp 200 Abtastwerte entsprechen dem direkt in den Empfänger 3 eingekoppelten Sendeimpuls. Die Laufzeit wird bevorzugt zwischen zwei aufeinanderfolgenden Echos bestimmt. Ein erstes Echo befindet sich in etwa bei dem Abtastwert 1000, das darauffolgende Mehrfachecho bei dem Abtastwert 2000. Die Abtastung ist in diesem Beispiel sehr hoch gewählt worden. Üblicherweise erfolgt die Abtastung mit typischen Abtastraten von 1 MHz bis 400 MHz.

Das empfangene, abgetastete Signal wird anschließend auf die benötigte zeitliche Genauigkeit Δt skaliert. Dies geschieht durch Einfügen von einer Null oder mehreren Nullen jeweils zwischen den tatsächlichen Abtastpunkten. Wenn beispielsweise die zeitliche Auflösung doppelt so groß wie die tatsächliche Abtastrate sein soll, so muss zwischen jeden Abtastwert eine "0" in den Datensatz eingefügt werden. Typische Werte für die zeitliche Genauigkeit sind 10ns, 1ns, 100ps.

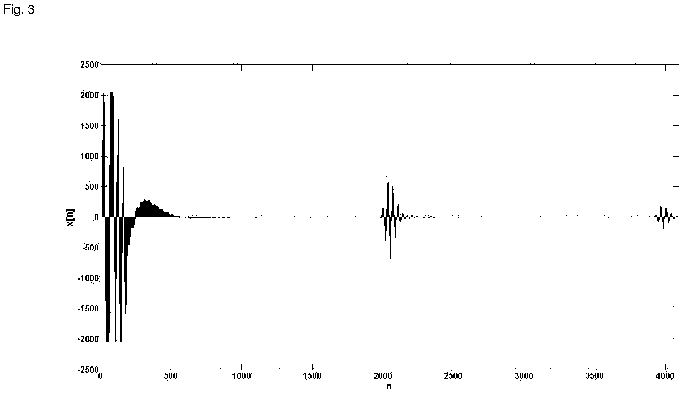

Die zeitliche Genauigkeit der Laufzeitbestimmung Δt ist infolge des Auffüllens mit Nullen ein ganzzahliges Vielfaches der Abtastrate. Das Ergebnis einer solchen Auffüllung mit Nullwerten des Empfangssignals aus Fig. 2 ist in Fig. 3 dargestellt. Durch die Nullwerte zwischen den Abtastwerten erscheinen die Flächen unter der einhüllenden Kurve ausgefüllt. In Fig. 3 wurde zwischen zwei Abtastwerten eine Null eingefügt. Daher liegen das erste Echo nunmehr ungefähr beim Abtastwert 2000 und das zweite Echo beim Abtastwert 4000.

Das Einfügen von zusätzlichen Nullen zwischen den originalen Messwerten beeinflusst das spektrale Verhalten. Dieses Verfahren erzeugt Artefakte im Spektrum. Durch die Vergrößerung des Frequenzbereichs können Alias-Frequenzanteile beeinflusst werden. Die Größe dieses Frequenzbereichs wird durch die Abtastrate und die Anzahl der einzufügenden Nullen bestimmt. Die durch Artefkate erzeugten Frequenzen müssen von der Bewertung ausgeschlossen werden. Diese Artefakte werden z. B. durch eine Tiefpassfilterung unterdrückt.

Letztlich wird die eigentliche Wavelet-Transformation mit dem festgelegten Basiswavelet Ψ und dem skalierten Empfangssignal $x_{skal}$ vorgenommen:

$$W_{diskr}(a,b) = \frac{1}{a} \sum_n \Psi\left(\frac{n-b}{a}\right) x_{skal}[n] \qquad (7)$$

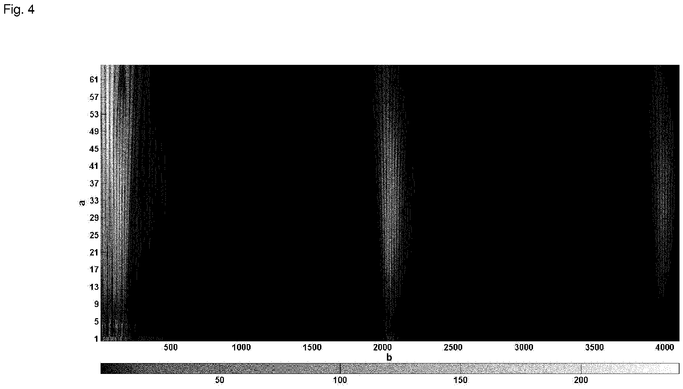

Das Ergebnis $W_{diskr}(a, b)$ einer solchen Wavelettransformation ist in Fig. 4 dargestellt. Die Grauwerte in der Grafik entsprechen den Werten der Wavelet-Transformierten W(a,b), die x-Achse zeigt den dazugehörigen Translationsparameter b, die y-Achse den Dilatationsparameter a. Dabei zeigt ein dunkler Wert der Funktion W(a, b) des "Vergleichs" von Basiswavelet und Empfangssignal mittels der Wavelet-Transformation, dass kein Zusammenhang zwischen dem Basiswavelet und dem Empfangssignal besteht. Ein heller Wert hingegen entspricht einem Zusammenhang von Basiswavelet und Empfangssignal. Bei kleinen Translationsparametern ist wiederum der direkt in den Empfänger 3 eingekoppelte Sendeimpuls zu sehen, bei Werten von ungefähr 2000 und 4000 die Echos.

In Figur 4 sind die Werte für b < 200, die dem Sendeimpuls entsprechen, in bevorzugter Ausgestaltung der Erfindung für die weitere Verarbeitung nicht von Interesse. Demzufolge wird nur der Bereich betrachtet, in dem die Echos zu erwarten sind, in dem vorliegenden, rein beispielhaften Ausführungsbeispiel zwischen 400≤ b ≤ 4096. Die Dauer des Ausschwingens des Sendeimpulses wird durch das Messsystem bestimmt und ist dem Anwender bekannt. Somit kann dieser Bereich leicht für die Auswertung bestimmt und dann nicht berücksichtigt werden.

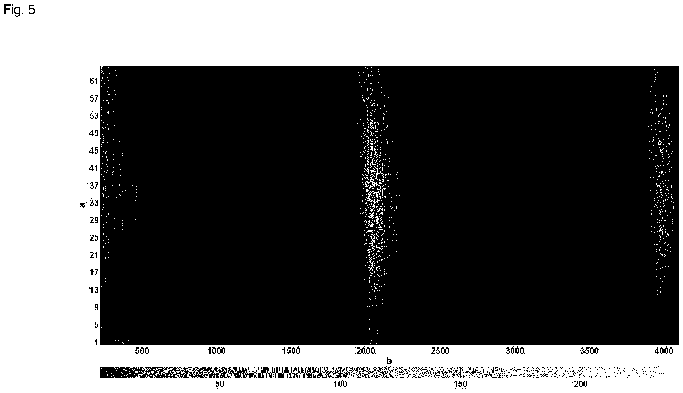

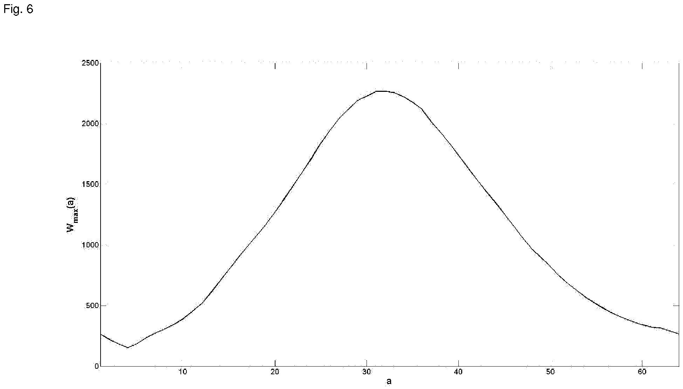

Aus diesem reduzierten Bereich von W(a, b), der in Figur 5 dargestellt ist, wird nun der optimale Wert für die Skalierung des Wavelets bestimmt. Dazu wird aus W(a, b) zu jeder Skalierung a das Maximum von W für ein beliebiges b ermittelt. Daraus ergibt sich das in Figur 6 dargestellte $W_{max}(a)$.

Die optimale Skalierung $a_{opt}$ ergibt sich aus der Position des Maximums in $W_{max}(a)$. Im vorliegenden Fall liegt das Maximum wie in Figur 6 dargestellt bei $a_{opt}$=33. Alternativ ist auch die Bestimmung des Energieinhaltes zu jeder Skalierung möglich.

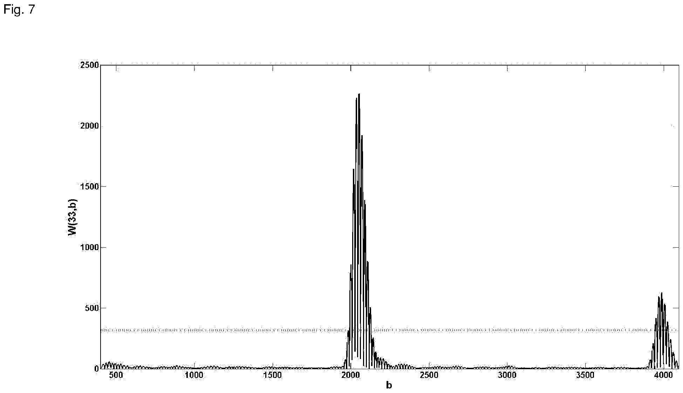

Daraufhin wird die Wavelet-Transformierte mit der ermittelten optimalen Skalierung $a_{opt}$ aus W(a, b) extrahiert. Mit anderen Worten, aus der Funktion W(a,b) wird $W(a_{opt},b)$, also im Ausführungsbeispiel W(33, b) für alle b-Werte extrahiert. Die Wavelet-Transformierte ist in Figur 7 dargestellt. Auch das Ergebnis der Wavelet-Transformation $W(a_{opt}, b)$ wird nur für den Echobereich verwendet, da die Laufzeit beispielhaft zwischen zwei aufeinanderfolgenden Echos bestimmt werden soll. Im vorliegenden Ausführungsbeispiel liegen die Echos im Bereich 400 ≤ b ≤ 4096.

In $W(a_{opt}, b)$ wird dann der Translationsparameter $b_{Echo1}$ für das erste Echo und $b_{Echho2}$ für das zweite Echo des Ultraschallmessimpulses durch Verwendung etablierter Verfahren zur Auswertung von Ultraschallsignalen bestimmt. Für die Laufzeitmessung kommen neben dem Maximum auch andere charakteristische Punkte in Frage. Dies können zum Beispiel der Echobeginn oder die Echomitte sein. Im gezeigten Ausführungsbeispiel wird das Maximum als charakteristischer Punkt der Echos verwendet.

Im nächsten Schritt werden die Laufzeiten beider Echos bestimmt:

$$t = b \ast \Delta t \tag{8}$$

Der zeitliche Abstand und somit die Laufzeit zwischen beiden Echos ergibt sich nach:

$$t = t_{Echo2} - t_{Echo1}$$

Die Erfindung wurde rein beispielhaft für das Impuls-Echo Verfahren und die Bestimmung der Laufzeit zwischen zwei Echos erläutert.

Jedoch ist das erfindungsgemäße Verfahren nicht auf die Reflektion eines Messimpulses in oder an einem Messobjekt beschränkt, sondern kann auch bei der Durchschallung eines Messobjektes verwendet werden. Bei der Reflektion sind Sender 1 und Empfänger 3 auf derselben Seite des Messobjektes angeordnet, bei der Durchschallung auf gegenüberliegenden Seiten. Ein Messimpuls wird über eine erste Seite des Messobjektes in das Messobjekt eingekoppelt, durchläuft das Messobjekt und verlässt es auf einer anderen, zweiten Seite. Hierbei wird wiederum der Zeitpunkt des Aussendens festgehalten oder gespeichert oder zu diesem Zeitpunkt der Empfänger 3 gestartet und dann das Empfangssignal an der zweiten Seite für die Wavelettransformation verwendet. Es wird also nur einmal der optimale Dilatationsparameter $a_{opt}$ bestimmt und darüber der zugehörige Parameter b und mit diesem die Laufzeit über Gleichung 8 bestimmt.

In der erfindungsgemäßen Vorrichtung ist die Recheneinheit 5 derart angepasst, dass die Schritte des erfindungsgemäßen Verfahrens ausgeführt werden können.

## Patentansprüche

1. Verfahren zur Bestimmung der Laufzeiten eines Ultraschallimpulses umfassend die Schritte:

   (a) Auswahl eines Basiswavelets;
   (b) Senden eines Ultraschallmessimpulses,
   (c) Durchlaufen einer Messstrecke,
   (d) Empfangen und Abtasten des ausgesendeten Ultraschallmessimpulses als Empfangssignal,
   (e) Skalieren des Empfangssignals auf eine Genauigkeit $\Delta t$ für die zu bestimmende Signallaufzeit umfassend: Einfügen von mindestens einer Null zwischen je zwei Abtastpunkten des Ultraschallmessimpulses derart, dass das Einfügen von $k$ Nullen mit $k \in N$ einer zeitlichen Genauigkeit von $\Delta t = \dfrac{\frac{1}{f_s}}{k+1}$ entspricht, wobei $f_s$ die Abtastrate des Empfangssignals ist,
   (f) Wavelet-Transformation auf Basis des ausgewählten Basiswavelets und des skalierten Empfangssignals, und
   (g) Bestimmung der Laufzeit des Ultraschallmessimpulses aus dem Ergebnis der Wavelettransformation,

   wobei das Ergebnis der Wavelet-Transformation eine Funktion W(a, b) ist, wobei der erste Parameter a der Wavelet-Transformation eine reelle Zahl ungleich Null ist, und der zweite Parameter b der Wavelet-Transformation eine natürliche Zahl ist und wobei der Schritt der Bestimmung der Laufzeit umfasst:

   Bestimmen des optimalen Wertes des ersten Parameters $a_{opt}$ des Wavelets umfassend die Schritte des Bestimmens des Maximums $W_{max}(a)$ aus W(a, b) separat zu jedem Wert des ersten Parameters a und für beliebige Werte des zweiten Parameters b, und des Bestimmens des optimalen Wertes des ersten Parameters $a_{opt}$ aus der Position des Maximums von $W_{max}(a)$;
   Auswählen der Wavelet-Transformation mit dem optimalen Wert des ersten Parameters $W(a_{opt}, b)$,
   Bestimmen des zweiten Parameters b an dessen Stelle der zum Ultraschallmessimpuls gehörige Impuls im Empfangssignal liegt, und Bestimmen der Laufzeit des Ultraschallmessimpulses aus dem Produkt des bestimmten zweiten Parameters b und der zeitlichen Genauigkeit $\Delta t$.

2. Verfahren nach Anspruch 1, wobei der Schritt des Auswählens eines Basiswavelets ferner die Schritte umfasst:

   Auswählen des Basiswavelets aus einer Gruppe von bekannten Basiswavelets, insbesondere Haar-, Daubechies-, biorthogonale Basiswavelets; oder
ein Basiswavelet erzeugt wird,
Minimierung der Abweichung des ausgewählten oder erzeugten Basiswavelets zu dem Empfangssignal.

3. Verfahren nach einem der vorhergehenden Ansprüche, wobei die Ultraschallmessimpulse durch breitbandige Signale im Bereich zwischen 500 kHz und 200 MHz erzeugt werden.

4. Verfahren nach einem der vorhergehenden Ansprüche, wobei zu Beginn des Verfahrens die Abtastrate des Ultraschallmessimpulses und die gewünschte zeitliche Auflösung der zu bestimmenden Laufzeit festgelegt werden.

5. Verfahren nach Anspruch 4, wobei ferner ein Schwellwert zu Unterscheidung eines Signals von Untergrundrauschen in der Wavelet-Transformierten festgelegt wird.

6. Verfahren nach einem der vorhergehenden Ansprüche, wobei die zeitliche Auflösung des skalierten Empfangssignals ein Vielfaches der zeitlichen Auflösung des Empfangssignals selbst ist.

7. Vorrichtung zur Bestimmung der Laufzeit eines Messimpulses bestehend aus einem Sender (1), einer Sonde (2), einem Empfänger (3), einer mit dem Sender (1) und dem Empfänger (3) verbundenen Recheneinheit (5) und einem Speicher, wobei die Recheneinheit (5) dazu ausgelegt ist, das Verfahren nach einem der Ansprüche 1 bis 6 auszuführen.

**Claims**

1. A method for determining the propagation times of an ultrasonic pulse, comprising the steps of:

   (a) selecting a base wavelet;
   (b) sending an ultrasonic measuring pulse,
   (c) passing through a measuring section,
   (d) receiving and sampling the emitted ultrasonic measuring pulse as a received signal,
   (e) scaling the received signal to an accuracy $\Delta t$ for the signal propagation time to be determined, comprising: inserting at least one zero between each two sampling points of the ultrasonic measuring pulse such that the inserting of $k$ zeroes at $k \in N$ corresponds to a temporal accuracy of $\Delta t = \dfrac{\frac{1}{fs}}{k+1}$, wherein $f_S$ is the sampling rate of the received signal,
   (f) performing a wavelet transformation on the basis of the selected base wavelet and the scaled received signal, and
   (g) determining the propagation time of the ultrasonic measuring pulse from the result of the wavelet transformation,

   wherein the result of the wavelet transformation is a function W(a, b), wherein the first parameter a of the wavelet transformation is a real nonzero number, and the second parameter b of the wavelet transformation is a natural number, and wherein the step of determining the propagation time comprises:

   determining the optimum value of the first parameter $a_{opt}$ of the wavelet, comprising the steps of determining the maximum $W_{max}(a)$ from W(a, b) separately to each value of the first parameter a and for any values of the second parameter b, and of determining the optimum value of the first parameter $a_{opt}$ from the position of the maximum of $W_{max}(a)$;
   selecting the wavelet transformation with the optimum value of the first parameter $W(a_{opt}, b)$,
   determining the second parameter b, at the location of which the pulse belonging to the ultrasonic measuring pulse lies in the received signal, and
   determining the propagation time of the ultrasonic measuring pulse from the product of the determined second parameter b and the temporal accuracy $\Delta t$.

2. The method according to Claim 1, wherein the step of selecting a base wavelet further comprises the steps of:

   selecting the base wavelet from a group of known base wavelets, in particular Haar, Daubechies, biorthogonal base wavelets; or a base wavelet is generated,
minimizing the deviation of the selected or generated base wavelet with respect to the received signal.

3.  The method according to any one of the preceding claims, wherein the ultrasonic measuring pulses are generated by broadband signals in the range between 500 kHz and 200 MHz.

4.  The method according to any one of the preceding claims, wherein the sampling rate of the ultrasonic measuring pulse and the desired temporal resolution of the propagation time to be determined are specified at the start of the method.

5.  The method according to Claim 4, wherein a threshold value is further specified to distinguish a signal from underground noises in the wavelet transform.

6.  The method according to any one of the preceding claims, wherein the temporal resolution of the scaled received signal is many times the temporal resolution of the received signal itself.

7.  A device for determining the propagation time of a measuring pulse, consisting of a transmitter (1), a probe (2), a receiver (3), a computer unit (5) connected to the transmitter (1) and the receiver (3) and a memory, wherein the computer unit (5) is designed to execute the method according to any one of Claims 1 to 6.

**Revendications**

1.  Procédé de détermination des temps de propagation d'une impulsion ultrasonore, comprenant les étapes:

    (a) sélection d'une ondelette de base ;
    (b) émission d'une impulsion de mesure ultrasonore,
    (c) parcours d'un trajet de mesure,
    (d) réception et échantillonnage de l'impulsion de mesure ultrasonore émise en tant que signal de réception,
    (e) mise à l'échelle du signal de réception avec une précision $\Delta t$ pour le temps de propagation de signal à déterminer, comprenant : insertion d'au moins un zéro entre deux points d'échantillonnage de l'impulsion de mesure ultrasonore, de telle manière que l'insertion de $k$ zéros avec $k \in N$ correspond à une précision temporelle

    de $\Delta t = \dfrac{\frac{1}{f_S}}{k+1}$, où $f_S$ est le taux d'échantillonnage du signal de réception,

    (f) transformée en ondelettes sur la base de l'ondelette de base sélectionnée et du signal de réception mis à l'échelle, et
    (g) détermination du temps de propagation de l'impulsion de mesure ultrasonore à partir du résultat de la transformée en ondelettes,

    où le résultat de la transformée en ondelettes est une onction W(a, b), où le premier paramètre a de la transformée en ondelettes est un nombre réel non égal à zéro, et le deuxième paramètre b de la transformée en ondelettes est un entier naturel et où l'étape de détermination du temps de propagation comprend :

    la détermination de la valeur optimale du premier paramètre $a_{opt}$ de rondelette, comprenant les étapes de détermination du maximum $W_{max}(a)$ à partir de W(a, b) séparément pour chaque valeur du premier paramètre a et pour des valeurs quelconques du deuxième paramètre b, et de détermination de la valeur optimale du premier paramètre $a_{opt}$ à partir de la position du maximum de $W_{max}(a)$ ;
    la sélection de la transformée en ondelettes avec la valeur optimale du premier paramètre $W(a_{opt}, b)$,
    la détermination du deuxième paramètre b à la place duquel est présentée l'impulsion appartenant à l'impulsion de mesure ultrasonore dans le signal de réception, et la détermination du temps de propagation de l'impulsion de mesure ultrasonore à partir du produit du deuxième paramètre b déterminé et de la précision temporelle $\Delta t$.

2.  Procédé selon la revendication 1, où l'étape de sélection d'une ondelette de base comprend en outre les étapes:

    la sélection de l'ondelette de base dans un groupe d'ondelettes de base connues, en particulier des ondelettes de base de Haar, de Daubechies, biorthogonales ; ou
    une ondelette de base est générée,

la minimisation de l'écart de l'ondelette de base sélectionnée ou générée par rapport au signal de réception.

3. Procédé selon l'une quelconque des revendications précédentes, où les impulsions de mesure ultrasonores sont générées par des signaux à large bande dans la plage entre 500 kHz et 200 MHz.

4. Procédé selon l'une quelconque des revendications précédentes, où le taux d'échantillonnage de l'impulsion de mesure ultrasonore et la résolution temporelle souhaitée du temps de propagation à déterminer sont fixés au début du procédé.

5. Procédé selon la revendication 4, où une valeur seuil pour la distinction d'un signal par rapport à des bruits de fond est en outre fixée dans la transformée en ondelettes.

6. Procédé selon l'une quelconque des revendications précédentes, où la résolution temporelle du signal de réception mis à l'échelle est un multiple de la résolution temporelle du signal de réception en tant que tel.

7. Dispositif pour la détermination du temps de propagation d'une impulsion de mesure, comprenant un émetteur (1), une sonde (2), un récepteur (3), une unité de calcul (5) reliée à l'émetteur (1) et au récepteur (3) et une mémoire, l'unité de calcul (5) étant prévue pour exécuter le procédé selon l'une quelconque des revendications 1 à 6.

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005015456 A1
- EP 2369334 A1

**In der Beschreibung aufgeführte Nicht-Patentliteratur**

- **GUETBI C et al.** Flow velocity estimation using ultrasound signals and wavelet transformation. INDUS-TRIAL ELECTRONICS SOCIETY, 1998
- **1998-08-31.** IECON '98. PROCEEDINGS OF THE 24TH ANNUAL CONFERENCE OF THE IEEE AACHEN. IEEE, vol. 3, 1366-1369
- **GRIMALDI D ED-YATSKIV N.** Time-of-flight measurement in ultrasound transducer by means of wavelet networks. *INTELLIGENT DATA ACQUISITION AND ADVANCED COMPUTING SYSTEMS: TECHNOLOG Y AND APPLICATIONS,* 2003
- PROCEEDINGS OF THE SECOND IEEE INTERNATIONAL WORKSHOP. IEEE, 08. September 2003, 365-370